(19) Europäisches Patentamt
European Patent Office
Office européen des brevets

(11) **EP 2 178 011 A1**

(12) **EUROPEAN PATENT APPLICATION**

(43) Date of publication:
**21.04.2010 Bulletin 2010/16**

(51) Int Cl.:
*G06F 17/50* [(2006.01)]   *H04R 25/00* [(2006.01)]

(21) Application number: **09172553.1**

(22) Date of filing: **08.10.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **10.10.2008   US 104399 P**
**05.10.2009   US 573216**

(71) Applicant: **Siemens Corporation**
**Iselin, NJ 08830 (US)**

(72) Inventors:
• **Zouhar, Alexander**
**Plainsboro, NJ 08536 (US)**
• **Baloch, Sajjad**
**Monmouth Junction, NJ 08852 (US)**
• **Azernikov, Sergei**
**Princeton, NJ 08540 (US)**
• **Xie, Hui**
**Plainsboro, NJ 08536 (US)**
• **Fang, Tong**
**Morganville, NJ 07751 (US)**

(74) Representative: **Clarke, Alison Clare**
**Haseltine Lake LLP**
**Redcliff Quay**
**120 Redcliff Street**
**Bristol BS1 6HU (GB)**

(54) **Point-based shape matching and distance applied to ear canal models**

(57)   A method for determining a degree of similarity between ear canal models includes receiving a first mesh model representing an inner surface of a first ear (S11). A set of points is sampled within the first mesh model (S13). Each of the sampled set of points is matched to a corresponding point of a second mesh model representing an inner surface of a second ear (S14). A shape distance between the first mesh model and the second mesh model is calculated based on the matched sets of points (S16). A determination of the degree of similarity between the inner surface of the first ear and the inner surface of the second ear is provided based on the calculated shape distance.

Fig. 1

Receive Two Mesh Models (X,X') — S11

Perform Segmentation of X and X' to Identify the Canal Structure of X and X' — S12

Point Sampling from the Canal Structures to Determine P and P' — S13

Point Matching to Identify Point-to-Point Correspondences between points P and points P' — S14

Iteration e.g. n times

Alignment — S15

Calculate Shape Distance Based on Final Point-to-Point Correspondences — S16

EP 2 178 011 A1

**Description**

## CROSS-REFERENCE TO RELATED APPLICATION

The present application is based on provisional application Serial No. 61/104,399, filed October 10, 2008, the entire contents of which are herein incorporated by reference.

## BACKGROUND OF THE INVENTION

### 1. Technical Field

The present disclosure relates to ear canal models and, more specifically, to point-based shape matching and distance applied to ear canal models.

### 2. Discussion of Related Art

Digital shape modeling is the process by which the shape of a device to be manufactured is designed with the assistance of computer aided design (CAD) software. After the desired shape is modeled in CAD software, the model file may be used in fabrication to produce a device with the desired shape. The use of digital shape modeling is widespread, however, when used for the modeling of organic shapes, such as in the field of medical prostheses, the complexity, irregularity and uncertainty of shapes can pose particular problems for digital shape modeling. One important example is the field of custom hearing aid manufacture.

A hearing aid is an electroacoustic device for the amplification of sound. Modem hearing aids may be worn either partially or fully within the ear canal. Examples of such hearing aids include in the canal (ITC), mini canal (MIC), and completely in the canal (CIC) aids. For these types of hearing aids, the entire hearing aid is designed to fit securely in the wearer's ear. To achieve this secure fit, the hearing aid is incorporated into an outer shell that is custom fitted to the shape of the wearer's ear canal.

Custom fitting of the hearing aid shell is accomplished by first taking an impression of the wearer's ear canal. This may be achieved by applying hardening foam or other molding substance into the ear of the wearer. Once removed and allowed to harden, the three-dimensional shape of the mold may be digitally scanned and imported into CAD software. Technicians may then perform various modifications and transformations to the three-dimensional geometry to convert the geometry of the wearer's ear into a model for fabricating the shell of a hearing aid. These geometry processing steps may be labor intensive, tedious and prone to error. These factors may then add to the cost and time required to produce a suitable hearing aid.

## SUMMARY

A method for determining a degree of similarity between ear canal models includes receiving a first mesh model representing an inner surface of a first ear. A set of points is sampled within the first mesh model. Each of the sampled set of points is matched to a corresponding point of a second mesh model representing an inner surface of a second ear. A shape distance between the first mesh model and the second mesh model is calculated based on the matched sets of points. A determination of the degree of similarity between the inner surface of the first ear and the inner surface of the second ear is provided based on the calculated shape distance.

Sampling the set of points within the first mesh model may include identifying a randomly selected set of points within the first mesh model and/or identifying a set of points within the first mesh model at predetermined regular increments.

Segmentation may be performed within the first mesh model to identify a plurality of regions. Thereafter one or more regions of interest may be selected and data pertaining to regions that are not of interest may be removed from the first mesh model such that the first mesh model is reduced to one or more regions of interest. The regions of interest may be an ear canal.

The shape distance between the first mesh model and the second mesh model may be calculated as the cumulative difference between each set of corresponding points between the first mesh model and the second mesh model.

After the matching of each of the sampled set of points to a corresponding point of the second mesh model, an alignment step may be performed to adjust characteristics of the points of the first mesh model to more closely conform to the second mesh model. Adjusting the characteristics of the first mesh model may include one or more of adjusting rotation, performing translation, or adjusting scale. After the alignment step is performed, the matching step may be repeated to establish an improved point-to-point correspondence. The matching step and alignment step may be repeated to iteratively improve the matching.

The step of matching each of the sampled set of points to a corresponding point of the second mesh model may include, for each point of the first mesh model, calculating a histogram representing the entire first mesh model from the point of view of each point in a radial dimension, an inclination angle and an azimuth angle and comparing that three-dimensional histogram to similar three-dimensional histograms of points of the second mesh model until a match is found.

The provided determination as to the degree of similarity between the inner surface of the first ear and the inner surface of the second ear may be used to transform the first mesh model into a design for a hearing aid to be placed into the first ear.

The first mesh model may be transformed into a design for a hearing aid using a geometry processing routine, the implementation of which may be dependent upon the calculated shape distance between the first mesh model and the second mesh model.

A shape distance between the first mesh model and a third mesh model representing an inner surface of a third ear may be calculated and may then be compared to the calculated shape distance between the first mesh model and the second mesh model to determine whether the inner surface of the first ear is more similar to the inner surface of the second ear or the inner surface of the third ear.

A first geometry processing routine may be performed on the first mesh model if the inner surface of the first ear is more similar to the inner surface of the second ear and a second geometry processing routine is performed on the first mesh model if the inner surface of the first ear is more similar to the inner surface of the third ear.

A system for designing a hearing aid device includes receiving a first mesh model representing an inner surface of a first ear, sampling a set of points within the first mesh model, matching each of the sampled set of points to a corresponding point of a second mesh model representing an inner surface of a second ear, calculating a shape distance between the first mesh model and the second mesh model based on the matched sets of points, and performing a geometry processing routine that is dependent upon the calculated shape distance between the first mesh model and the second mesh model to transform the first mesh model into a design for a hearing aid to be placed into the first ear.

Sampling the set of points within the first mesh model may include identifying a randomly selected set of points within the first mesh model or identifying a set of points within the first mesh model at predetermined regular increments.

Segmentation may be performed within the first mesh model to identify a plurality of regions. Thereafter one or more regions of interest may be selected and data pertaining to regions that are not of interest may be removed from the first mesh model such that the first mesh model is reduced to one or more regions of interest. The regions of interest may be an ear canal.

The shape distance between the first mesh model and the second mesh model may be calculated as the cumulative difference between each set of corresponding points between the first mesh model and the second mesh model.

After the matching of each of the sampled set of points to a corresponding point of the second mesh model, an alignment step may be performed to adjust characteristics of the points of the first mesh model to more closely conform to the second mesh model.

The step of matching each of the sampled set of points to a corresponding point of the second mesh model may include, for each point of the first mesh model, calculating a histogram representing the entire first mesh model from the point of view of each point in a radial dimension, an inclination angle and an azimuth angle and comparing that three-dimensional histogram to similar three-dimensional histograms of points of the second mesh model until a match is found.

A computer system includes a processor and a program storage device readable by the computer system, embodying a program of instructions executable by the processor to perform method steps for determining a degree of similarity between ear canal models. The method includes receiving a first mesh model representing an inner surface of a first ear, sampling a set of points within the first mesh model, matching the sampled set of points to corresponding points of a second mesh model representing an inner surface of a second ear, calculating a shape distance between the first mesh model and the second mesh model based on the matching, and outputting the calculated shape distance.

## BRIEF DESCRIPTION OF THE DRAWINGS

A more complete appreciation of the present disclosure and many of the attendant aspects thereof will be readily obtained as the same becomes better understood by reference to the following detailed description when considered in connection with the accompanying drawings, wherein:

FIG. 1 is a flow chart illustrating an approach for computing the shape distance between corresponding anatomical structures of two three-dimensional mesh models according to an exemplary embodiment of the present invention;
FIG. 2 is an illustration of a surface geometry of an ear divided into an external ear surface and an ear canal surface in accordance with an exemplary embodiment of the present invention;

FIG. 3 is a flow chart illustrating an approach for hearing aid design using shape categories according to an exemplary embodiment of the present invention; and

FIG. 4 shows an example of a computer system capable of implementing the method and apparatus according to embodiments of the present disclosure.

## DETAILED DESCRIPTION OF THE DRAWINGS

In describing exemplary embodiments of the present disclosure illustrated in the drawings, specific terminology is employed for sake of clarity. However, the present disclosure is not intended to be limited to the specific terminology so selected, and it is to be understood that each specific element includes all technical equivalents which operate in a similar manner.

Exemplary embodiments of the present invention seek to provide for an automated or partially automated approach to hearing aid modeling and design whereby geometry processing steps traditionally performed by a CAD technician may be partially or fully automated. As anatomical shapes such as that of the ear canal may be substantially different from patient to patient, it may be difficult to apply the same automatic processing steps to every ear canal. Accordingly, exemplary embodiments of the present invention first seek to differentiate between various classifications of ear canal shapes so that automated geometry processing may be specific to the particular class of shape that any given ear canal most conforms to. This classification may be performed using the concept of shape distances whereby the differentiation between a given ear canal and a model ear canal may be quantified as a distance. By calculating the shape distance between a given ear canal and a model ear canal, it may be determined whether the automated geometry processing techniques established for the model ear canal may be successfully applied to the given ear canal and/or what shape class-specific geometry processing rules to apply for the given context. Moreover, where there are multiple model ear canals each with corresponding sets of automated geometry processing techniques, shape distances may be calculated between the given ear canal and each of the multiple model ear canals so that a best match may be found and the corresponding set of automated geometry processing techniques may be applied.

Accordingly, exemplary embodiments of the present invention may make use of a meaningful notion of shape distance. This task may be closely coupled to the problem of establishing pointwise correspondences between two subjects, in this case, the given ear canal and the model ear canal. Pointwise correspondences may be particularly difficult for thee-dimensional surfaces, especially for organic shapes, where anatomical variations make automatic solutions for landmark detection very challenging. Exemplary embodiments of the present invention may utilize a three-dimensional shape context to define a non-Euclidian shape metric space between canal structures of the ear anatomy models and the given ear canals, where points are chosen uniformly at random from each exemplar. Here, point matching and similarity transformation may be reiterated for mutual improvement. By using this approach, shape matching may be performed to an extent that is commensurate with the human notion of shape categorization and at the same time robust towards reasonable amounts of noise and matching outliers. Thus the accuracy of human shape categorization may be achieved without the need for human input. By the use of this approach, various classifications of digital hearing aid design process may be established and for the manufacturing of a given hearing aid, a classification may easily be determined to provide for a selection of an optimal processing path.

Exemplary embodiments of the present invention compare the shape of canal parts of a human outer ear to one or more three-dimensional models. Three-dimensional models of the outer ear may be represented as bounded triangular meshes. Shape classes may be identified for several anatomical parts of outer ear three-dimensional models including the canal part. To this end, a meaningful notion of shape distance may be provided to differentiate between subjects in a population of shapes. Shape classes of anatomical parts may be used to derive shape class specific rules for the manipulation of outer ear surface geometries in hearing aid design.

The correspondence computation may be based on invariant attributes of point locations to ensure that the resulting shape distance is invariant with respect to a chosen finite dimensional group (e.g., the similarity group) and to additional non-ideal conditions, such as noise and small local deformations. Exemplary embodiments of the present invention utilize shape context in order to establish point correspondence between two ear canal shapes. These correspondences may be determined by solving a linear assignment problem. It may be assumed herein that corresponding points on similar three-dimensional canal shapes have similar shape context distributions, despite the presence of small local deformations and reasonable amounts of noise.

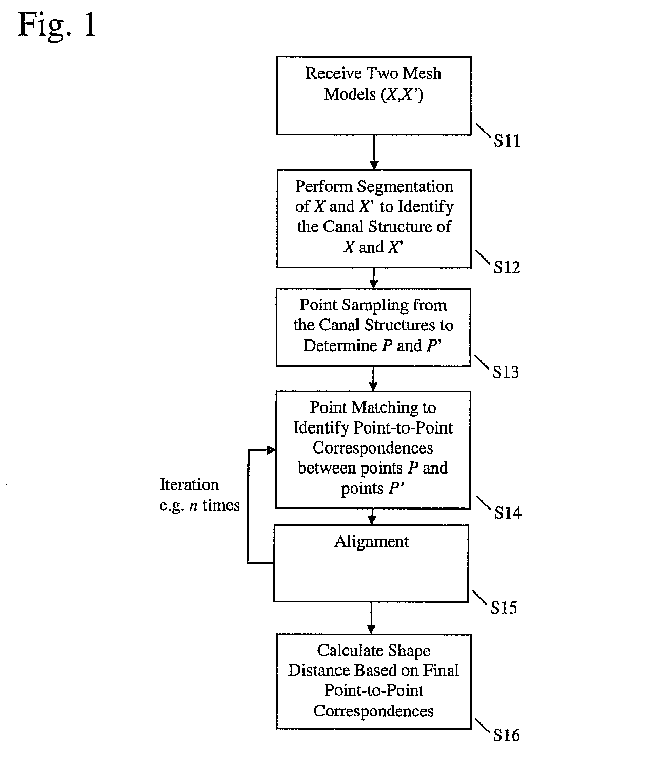

FIG. 1 is a flow chart illustrating an approach for computing the shape distance between corresponding anatomical structures of two three-dimensional mesh models according to an exemplary embodiment of the present invention. As described herein, the shape distance may be expressed as $D^I(X,X')$ where $X$ is the first three-dimensional mesh model, for example, a given ear shape being categorized and $X'$ is the second three-dimensional mesh model, for example, an ear shape of a known shape class. The shape distance $D^I$ is calculated for all $I$ wherein $I$ is the set of corresponding anatomical regions $I \in \{1,...,M\}$.

First, the two three-dimensional mesh models (*X,X'*) are received (Step S 11). As discussed above, the first three-dimensional mesh model *X* may be the given ear shape being categorized and the second three-dimensional mesh model *X'* may be the ear shape of a known shape class.

The three-dimensional mesh models may be geometric representations of the inner surface of an ear. These geometries may be restricted to surface imagery although the presence of image data reflecting internal structures need not prevent exemplary embodiments of the present invention from utilizing such image data.

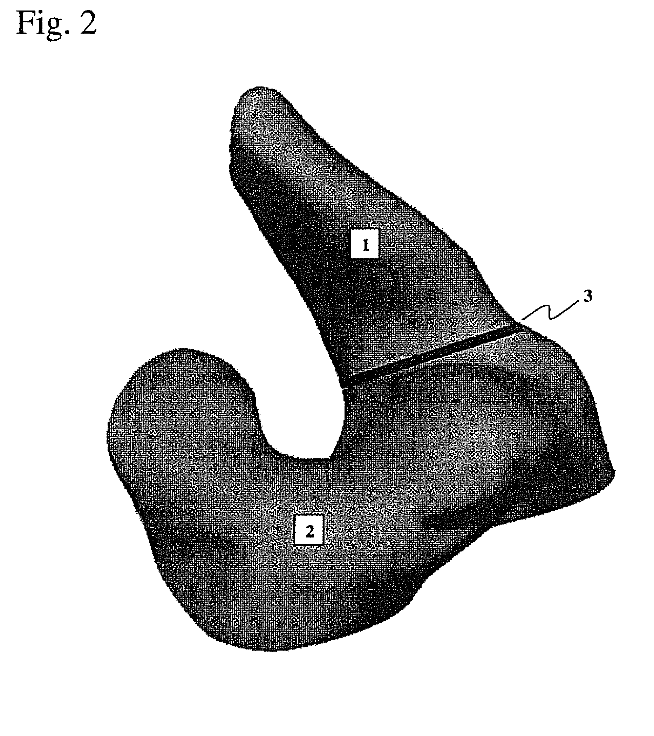

Next, segmentation may be performed on each three-dimensional mesh model to determine each of a set of anatomical regions, which may include, for example, a canal structure (*l*=1) and an external ear structure (*l*=2) (Step S12). An example of segmentation may be seen in FIG. 2 where the ear surface mesh model has been segmented into an external ear structure 2 and a canal structure 1. Here, the plane of separation 3 between the ear canal 1 and the external ear 2 has been identified.

Where one of the three-dimensional mesh models is in fact a known ear shape of a particular shape class, the complete set of anatomical regions may be already segmented, in which case segmentation is performed only with respect to the given ear shape being categorized. Where neither three-dimensional mesh models is known, segmentation may be performed for each model.

Segmentation may be performed within the mesh models to identify multiple regions. Thereafter one or more regions of interest may be selected from among the multiple regions. As described above, the mesh model may be divided into two regions including a canal region and an external ear region. In such a case, the canal region may be considered the region of interest. Data pertaining to regions that are not of interest may be removed from the mesh models such that the mesh models is reduced to one or more regions of interest. Here, the external ear region may be removed and the mesh models may be reduced to include only the ear canal.

Decomposition of the triangular meshes into distinct anatomical regions, for example, the external ear and the canal, may be automatically performed as part of the segmentation step. By removing the regions that are not of interest, point matching and subsequent processing steps may be simplified.

Point sampling may then be performed on each mesh model to characterize each mesh model as a collection of points that is a sample of the complete set of vertices of the corresponding mesh model. Sampling may be performed, for example, either randomly or at fixed intervals. The result is a set of points *P* representing the first mesh model *X* and a set of points *P'* representing the second mesh model. It may also be possible to skip the step of point sampling and instead consider the full set of vertices as the set of points, however, to make efficient use of limited computational resources, sampling may be used.

Point matching may then be performed to determine point-for-point correspondences between the points of the sets of points *P* and *P'* (Step S14). The result of point matching is to determine which point from *P* corresponds to which point from *P'* for all points, or at least for all points that have analogs. Correspondences may be established between two point sets *P* and *P'*, for example, by employing a shape context, which in three-dimensions, for a given point $p \in P$ and $p' \in P'$ is a descriptor that measures the loci of all other points $\hat{p} \in P$ and $\hat{p}' \in P'$ relative to *p* and *p'* based on a three-dimensional statistic of spherical coordinates ($r,\theta,\varphi$), where *r* denotes the radial dimension, and $\theta$ and $\varphi$ are angles denoting the elevation and azimuth dimensions, respectively. The resulting correspondence is a quantification of how the entire shape appears from the point of view of each particular sample point and by comparing this quantification from a point *p* of the first mesh model with a point *p'* on the second mesh model, the degree of correspondence may be ascertained. Then, a global cost function may be produced by the sum of pairwise correspondences. Optimal correspondence may then be solved for, for example, using bipartite matching. Optimal correspondences, herein, represent the point matching.

After establishing correspondences between the two point sets *P* and *P'* (point matching), alignment may be performed. Alignment represents the steps necessary to align the set of points *P* and with the set of points *P'*, based on the previously-determined point matching. Alignment may include, for example, an adjustment of the rotation, translation, and scale in a manner that best aligns *P* with *P'*. Alignment may, in the simplest example, be linear, however, non-ridged transformations may also be used. For the purpose of ease of explanation, exemplary embodiments of the present invention are described herein utilizing rigid alignment.

The steps of point matching (S 14) and alignment (S15) may be performed iteratively the step of performing the alignment may allow for a more accurate subsequent point matching, and that in turn may allow for a more accurate subsequent alignment. Accordingly, these steps may be repeated either for a predetermined number of iterations, for example, *n* where *n* is a positive integer, for example, 2, or repetition may continue until the point at which subsequent iteration ceases to produce additional refinement.

In either event, after iteration has been completed, the shape distance between *P'* and *P'* may be calculated using the final point-to-point correspondences (Step S16). The calculated shape distance may then be used, for example, to determine how to process the geometry by choosing a geometry processing routine based on a shape category or by modifying geometry processing steps based on the calculated shape distance. According to some exemplary embodiments of the present invention, a patient's ear shape model *X* may be compared either to a single model *X'* or to multiple models *X''*,*X'''*, etc. By repeating the above-described process for multiple known shape models, a set of shape distances may be calculated for the model of the patient's ear so that, for example, a closest match may be found and a corresponding geometry processing routine followed. However, following the geometry processing routine for a closest match does not preclude the possibility that the geometry processing steps could be dependent upon one or more of the shape distances.

Exemplary embodiments of the present invention may accordingly measure the shape distance between canal parts of outer ear three-dimensional models. As the notion of shape distance may be symmetric, the correspondence may be expressed as a bijective mapping $\pi : P \to P'$ between two sets of points $P \subset X$, $P' \subset X'$ sampled from the canal part of a triangular mesh. Here, $P$ denotes the set of points sampled from the canal part of $X$, and $P'$ contains the points sampled from the canal part of $X'$.

A fixed number of points $N$ is sampled from the set of vertices $V$ of a triangular mesh. Hence, the point sets $P$ are elements of the $d$-dimensional space $R^d$, with $d = 3N$. The shape of a subsurface may be reasonably approximated with a roughly uniform spacing between points. It is not necessary that the sampled points correspond to anatomical landmarks or other key points such as the curvature extrema. The sampled points may thus be either randomly selected or selected at fixed intervals, for example, as described above.

The optimal correspondence mapping $\pi^*$ may be obtained by minimizing an appropriate energy functional, for example:

$$\pi^* = \arg\min_{\pi} Q(\pi) \qquad (1)$$

The shape distance $D^l(X,X')$, $l \in \{1,..., M\}$ between two corresponding parts $l$ of $X$ and $X'$ may be defined by:

$$D^l(X,X') = Q(\pi^*) \qquad (2)$$

The global cost of matching may be defined by assuming that $Q(\pi)$ is given by the sum of certain local costs. Accordingly, a function $q$ may be defined as $\Re^3 \times \Re^3 \to \Re$, which assigns a pair of matching points $p \in P$, $p' \in P'$ a scalar, that quantifies the local cost of matching. Thus, the global cost of matching may be given by:

$$Q(\pi) = \sum_{p \in P} q(p, \pi(p)) \qquad (3)$$

Shape contexts may be highly discriminative and thus may be inherently insensitive to small perturbations of parts of the shape. Scale invariance may be obtained by normalizing all radial distances of a shape context histogram. This may be achieved by computing twice the centroid size for a point set $P$ and $P'$, respectively. Rotation invariance may also be obtained.

A shape context may be formed by dividing each dimension into bins that are, for example, equally spaced in the angular dimensions and logarithmically spaced along the radial dimension. The optimal number of $r$-bins, $\theta$-bins and $\varphi$-bins may be known for example, having been determined through experimentation. The resulting total number of bins may be expressed as $K$. Each histogram bin $k$, $0 \le k < K$ may accumulate the number of points whose spherical coordinates relative to $p$ fall within the discrete interval represented by the $k$-th bin. Since shape contexts may be represented as normalized histograms, their distance can be computed for example by using the chi-squared test statistic:

$$q(p, p') = \frac{1}{2} \sum_{k=1}^{K} \frac{[H_p(k) - H_{p'}(k)]^2}{H_p(k) + H_{p'}(k)} \qquad (4)$$

where $H_p(k)$ and $H_{p'}(k)$ denote the $K$-bin normalized histogram at $p \in P$ and $p' \in P'$, respectively.

A robust treatment of matching outliers may be achieved by adding rows/columns with a constant (high) matching cost ε, which may be equivalent to adding "dummy" points to the point sets. In this case, a point would be matched to a "dummy" whenever there is no real match available at smaller cost than ε. As discussed above, the steps of point matching (S14) and alignment (S 15) can be iterated, for example, to increase robustness to potential matching outliers.

Alignment may be performed, for example, by using a similarity transform for the transformation of a three-dimensional point cloud. As discussed above, there may be two point sets $P$ and $P'$. Here, the point sets may be expressed as $P' = \{x_i | i = 1, ..., N\}$ and $P = \{y_i | i = 1, ..., N\}$. The goal of alignment may be to align $P'$ to $P$ and using a similarity transformation by minimizing the sum of square errors, i.e.:

$$E(R,T,\beta) = \sum_i^N \left\| y_i - \beta R x_i - T \right\|^2 \qquad (5)$$

where $R$, $T$, $\beta$ denote rotation, translation, and scale, respectively. Although a closed-form solution of Equation (5) can be derived, the variational approach may also be used to approximate the solution. The update equation for minimizing the objective function w.r.t. scale may simply be given by:

$$\frac{\partial \beta}{\partial t} = -\sum_i^N \left\langle \left[ \dot{x}_i - \beta R y_i - T \right], R y_i \right\rangle \qquad (6)$$

where $<\cdot,\cdot>$ denotes the inner product in three-dimensional Euclidian space.

Exemplary embodiments of the present invention provide a framework for computing the shape distance between canal structures of previously segmented outer ear models. To this end, the three-dimensional shape context has been employed to establish one-to-one point correspondences. The proposed shape distance may closely mimic the human notion of shape similarity. This framework may also be used to find clusters in a population of shapes, and to interpret the classes in terms of manufacturing categories. For increasing robustness of matching, an extension of the shape context descriptor, for example, the geodesic shape context, may be used. In so doing, the topology of triangular meshes may be incorporated in terms of geodesic distances between a histogram basis point and points located in the histogram bins. Additionally, a non-linear dimensionality reduction technique may be used to allow for a visual assessment of the sample distribution. Thereafter, clustering methodologies may be applied on the resulting lower dimensional embedding space.

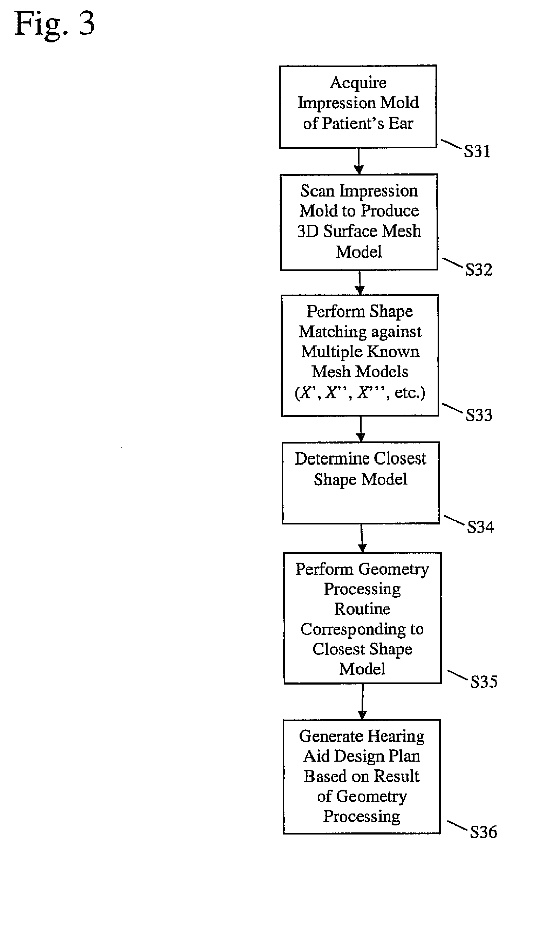

As discussed above, exemplary embodiments of the present invention may utilize multiple known three-dimensional mesh models so that the approach described above with respect to FIG. 1 may be performed with respect to each known mesh model so a closest fit shape, for example, defined as the mesh model with the smallest shape distance as compared to the mesh model produced from the patient's ear, may be found. FIG. 3 is a flow chart illustrating an approach for hearing aid design using shape categories according to an exemplary embodiment of the present invention. First, an impression mold of a patient's ear may be obtained (Step S31). This may be achieved, for example, by applying hardening foam or other molding substance into the ear of the wearer. Once removed and allowed to harden, the three-dimensional shape of the mold may be digitally scanned to produce a thee-dimensional digital surface geometry, referred to herein as the mesh model (Step S32).

Shape matching may then be performed against multiple known mesh models, which may be, for example, $X'$, $X''$, $X'''$, etc. (Step S33). Shape matching may be performed, for example, as described above with respect to FIG. 1 and may include all steps S 11 through S16. Shape matching may be performed using the shape model of the patient's ear against each of the multiple known mesh models.

After shape matching has been performed for each of the multiple mesh models, a closest shape model may be determined (Step S34). The closest shape model may be defined as the known shape model with the smallest shape distance to the shape model of the patient's ear.

As each of the multiple known mesh models may have a corresponding geometry processing routine for transforming the mesh model of the patient's ear into a form that is usable for constructing a custom-fitted hearing aid, the geometry processing routine corresponding to the closest known mesh model may be performed (Step S35). There may be a unique geometry processing routine for each known mesh model or there may be a single geometry processing routine that is customizable by a dependence upon the actual shape distances between the shape model for the patient's ear and one or more of the known mesh models. Exemplary embodiments of the present invention may also combine these approaches such that there is a unique geometry processing routine for each known mesh model and each unique geometry processing routine is dependent upon the calculated shape distances.

After the geometry processing routine is performed, and/or before the geometry processing routine is performed, additional automatic, manual or semiautomatic geometry processing steps may be performed to generate a design plan for a hearing aid based on the results of the performed geometry processing routine (Step S36).

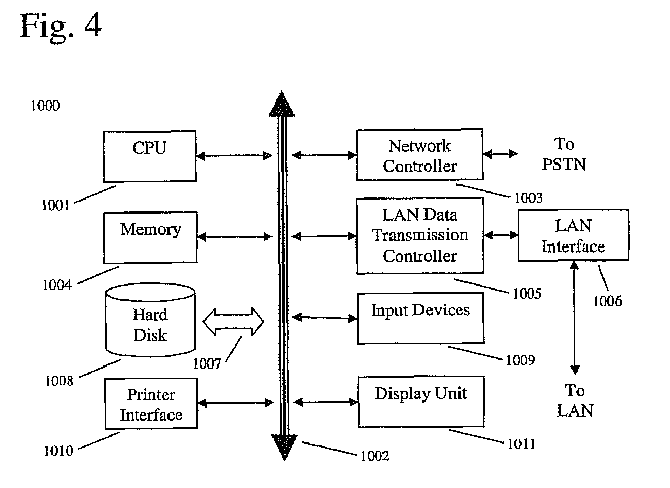

FIG. 4 shows an example of a computer system which may implement a method and system of the present disclosure. The system and method of the present disclosure may be implemented in the form of a software application running on a computer system, for example, a mainframe, personal computer (PC), handheld computer, server, etc. The software application may be stored on a recording media locally accessible by the computer system and accessible via a hard wired or wireless connection to a network, for example, a local area network, or the Internet.

The computer system referred to generally as system 1000 may include, for example, a central processing unit (CPU) 1001, random access memory (RAM) 1004, a printer interface 1010, a display unit 1011, a local area network (LAN) data transmission controller 1005, a LAN interface 1006, a network controller 1003, an internal bus 1002, and one or more input devices 1009, for example, a keyboard, mouse etc. As shown, the system 1000 may be connected to a data storage device, for example, a hard disk, 1005 via a link 1007.

Exemplary embodiments described herein are illustrative, and many variations can be introduced without departing from the spirit of the disclosure or from the scope of the appended claims. For example, elements and/or features of different exemplary embodiments may be combined with each other and/or substituted for each other within the scope of this disclosure and appended claims.

## Claims

1. A method for determining a degree of similarity between ear canal models, comprising:

   receiving a first mesh model representing an inner surface of a first ear;
   sampling a set of points within the first mesh model;
   matching each of the sampled set of points to a corresponding point of a second mesh model representing an inner surface of a second ear;
   calculating a shape distance between the first mesh model and the second mesh model based on the matched sets of points; and
   providing a determination of the degree of similarity between the inner surface of the first ear and the inner surface of the second ear based on the calculated shape distance,

   wherein the steps of receiving the first mesh model, sampling, matching calculating and providing are performed by a geometry processing device.

2. The method of claim 1, wherein the provided determination as to the degree of similarity between the inner surface of the first ear and the inner surface of the second ear is used to transform the first mesh model into a design for a hearing aid to be placed into the first ear.

3. The method of claim 2, wherein the first mesh model is transformed into a design for a hearing aid using a geometry processing routine, the implementation of which is dependent upon the calculated shape distance between the first mesh model and the second mesh model.

4. The method of claim 1, wherein a shape distance between the first mesh model and a third mesh model representing an inner surface of a third ear is calculated and is then compared to the calculated shape distance between the first mesh model and the second mesh model to determine whether the inner surface of the first ear is more similar to the inner surface of the second ear or the inner surface of the third ear.

5. The method of claim 4, wherein a first geometry processing routine is performed on the first mesh model when the inner surface of the first ear is more similar to the inner surface of the second ear and a second geometry processing routine is performed on the first mesh model when the inner surface of the first ear is more similar to the inner surface of the third ear.

6. A method for designing a hearing aid device, comprising:

   receiving a first mesh model representing an inner surface of a first ear;

sampling a set of points within the first mesh model;

matching each of the sampled set of points to a corresponding point of a second mesh model representing an inner surface of a second ear;

calculating a shape distance between the first mesh model and the second mesh model based on the matched sets of points; and

performing a geometry processing routine that is dependent upon the calculated shape distance between the first mesh model and the second mesh model to transform the first mesh model into a design for a hearing aid to be placed into the first ear,

wherein the steps of receiving, sampling, matching, calculating and performing are performed by one or more computer systems.

7. The method of claim 1 or 6, wherein sampling the set of points within the first mesh model includes identifying a randomly selected set of points within the first mesh model or identifying a set of points within the first mesh model at predetermined regular increments.

8. The method of claim 1 or 6, wherein segmentation is performed within the first mesh model prior to the step of sampling the set of points to identify a region of interest within the first mesh model and to reduce the first mesh model to include only geometry corresponding to the identified region of interest.

9. The method of claim 1 or 6, wherein the shape distance between the first mesh model and the second mesh model is calculated as the cumulative difference between each set of corresponding points between the first mesh model and the second mesh model.

10. The method of claim 1 or 6, wherein after the matching of each of the sampled set of points to a corresponding point of the second mesh model, an alignment step is performed to adjust characteristics of the points of the first mesh model to more closely conform to the second mesh model.

11. The method of claim 10, wherein adjusting the characteristics of the first mesh model includes one or more of adjusting rotation, performing translation, or adjusting scale.

12. The method of claim 10, wherein after the alignment step is performed, the matching step is repeated to establish an improved point-to-point correspondence.

13. The method of claim 10, wherein the matching step and alignment step are repeated to iteratively improve the matching.

14. The method of claim 1 or 6, wherein the step of matching each of the sampled set of points to a corresponding point of the second mesh model includes, for each point of the first mesh model, calculating a histogram representing the entire first mesh model from the point of view of each point in a radial dimension, an inclination angle and an azimuth angle and comparing that three-dimensional histogram to similar three-dimensional histograms of points of the second mesh model until a match is found.

15. A computer system comprising:

a processor; and

a program storage device readable by the computer system, embodying a program of instructions executable by the processor to perform method steps for determining a degree of similarity between ear canal models, the method comprising:

receiving a first mesh model representing an inner surface of a first ear;

sampling a set of points within the first mesh model;

matching the sampled set of points to corresponding points of a second mesh model representing an inner surface of a second ear;

calculating a shape distance between the first mesh model and the second mesh model based on the matching; and

outputting the calculated shape distance.

# Fig. 1

```
┌─────────────────────┐
│   Receive Two Mesh  │
│    Models (X,X')    │
└─────────────────────┘  S11
           │
           ▼
┌─────────────────────┐
│ Perform Segmentation│
│ of X and X' to Identify│
│ the Canal Structure of│
│       X and X'      │
└─────────────────────┘  S12
           │
           ▼
┌─────────────────────┐
│  Point Sampling from│
│ the Canal Structures to│
│  Determine P and P' │
└─────────────────────┘  S13
           │
           ▼
┌─────────────────────┐
│   Point Matching to │
│ Identify Point-to-Point│
│   Correspondences   │
│ between points P and│
│      points P'      │
└─────────────────────┘  S14
           │
           ▼
┌─────────────────────┐
│      Alignment      │
│                     │
└─────────────────────┘  S15
           │
           ▼
┌─────────────────────┐
│   Calculate Shape   │
│ Distance Based on Final│
│    Point-to-Point   │
│   Correspondences   │
└─────────────────────┘  S16
```

Iteration
e.g. $n$ times

Fig. 2

# Fig. 3

```
┌─────────────────────┐
│     Acquire         │
│  Impression Mold    │
│  of Patient's Ear   │
└─────────────────────┘ ～S31
          │
          ▼
┌─────────────────────┐
│  Scan Impression    │
│  Mold to Produce    │
│  3D Surface Mesh    │
│      Model          │
└─────────────────────┘ ～S32
          │
          ▼
┌─────────────────────┐
│   Perform Shape     │
│  Matching against   │
│  Multiple Known     │
│   Mesh Models       │
│ (X', X'', X''', etc.)│
└─────────────────────┘ ～S33
          │
          ▼
┌─────────────────────┐
│  Determine Closest  │
│    Shape Model      │
│                     │
└─────────────────────┘ ～S34
          │
          ▼
┌─────────────────────┐
│  Perform Geometry   │
│    Processing       │
│     Routine         │
│  Corresponding to   │
│  Closest Shape      │
│      Model          │
└─────────────────────┘ ～S35
          │
          ▼
┌─────────────────────┐
│  Generate Hearing   │
│  Aid Design Plan    │
│  Based on Result    │
│   of Geometry       │
│    Processing       │
└─────────────────────┘ ～S36
```

# Fig. 4

1000

| | | |
|---|---|---|
| CPU | | Network Controller | To PSTN |
| 1001 | | 1003 | |
| Memory | | LAN Data Transmission Controller | LAN Interface |
| 1004 | | 1005 | 1006 |
| Hard Disk | 1007 | Input Devices | |
| 1008 | | 1009 | |
| Printer Interface | | Display Unit | To LAN |
| 1010 | 1002 | 1011 | |

**Europäisches Patentamt**
**European Patent Office**
**Office européen des brevets**

# EUROPEAN SEARCH REPORT

Application Number

EP 09 17 2553

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | GOZDE UNAL ET AL: "Customized Design of Hearing Aids Using Statistical Shape Learning" 6 September 2008 (2008-09-06), MEDICAL IMAGE COMPUTING AND COMPUTER-ASSISTED INTERVENTION Â MICCAI 2008; [LECTURE NOTES IN COMPUTER SCIENCE], SPRINGER BERLIN HEIDELBERG, BERLIN, HEIDELBERG, PAGE(S) 518 - 526 , XP019105069 ISBN: 9783540859871 * the whole document * ----- | 1-15 | INV. G06F17/50 H04R25/00 |
| X | ALEXANDER ZOUHAR ET AL: "Anatomically-Aware, Automatic, and Fast Registration of 3D Ear Impression Models" 3D DATA PROCESSING, VISUALIZATION, AND TRANSMISSION, THIRD INTERNATION AL SYMPOSIUM ON, IEEE, PI, 1 June 2006 (2006-06-01), pages 240-247, XP031078947 ISBN: 978-0-7695-2825-0 * the whole document * ----- | 1-15 | |
| A | WO 2008/063510 A1 (SIEMENS MEDICAL SOLUTIONS [US]; ZOUHAR ALEXANDER [US]; SLABAUGH GREGOR) 29 May 2008 (2008-05-29) * abstract * * page 2 - page 4 * * page 7 - page 8 * ----- -/-- | 1-15 | TECHNICAL FIELDS SEARCHED (IPC) G06F H04R |

The present search report has been drawn up for all claims

| Place of search | Date of completion of the search | Examiner |
|---|---|---|
| Munich | 11 February 2010 | Radev, Boyan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt
European
Patent Office
Office européen
des brevets

**EUROPEAN SEARCH REPORT**

Application Number

EP 09 17 2553

| DOCUMENTS CONSIDERED TO BE RELEVANT | | | |
|---|---|---|---|
| Category | Citation of document with indication, where appropriate, of relevant passages | Relevant to claim | CLASSIFICATION OF THE APPLICATION (IPC) |
| A | SLABAUGH G ET AL: "3-D shape modeling for hearing aid design [Applications Corner]" IEEE SIGNAL PROCESSING MAGAZINE, IEEE SERVICE CENTER, PISCATAWAY, NJ, US, vol. 25, no. 5, 1 September 2008 (2008-09-01), pages 98-102, XP011233606 ISSN: 1053-5888 * the whole document * ----- | 1-15 | |
| A | EP 1 796 428 A1 (SIEMENS MEDICAL SOLUTIONS [US]) 13 June 2007 (2007-06-13) * the whole document * ----- | 1-15 | |
| | | | TECHNICAL FIELDS SEARCHED (IPC) |

The present search report has been drawn up for all claims

| Place of search | Date of completion of the search | Examiner |
|---|---|---|
| Munich | 11 February 2010 | Radev, Boyan |

**EP 2 178 011 A1**

## ANNEX TO THE EUROPEAN SEARCH REPORT
## ON EUROPEAN PATENT APPLICATION NO.

EP 09 17 2553

This annex lists the patent family members relating to the patent documents cited in the above-mentioned European search report.
The members are as contained in the European Patent Office EDP file on
The European Patent Office is in no way liable for these particulars which are merely given for the purpose of information.

11-02-2010

| Patent document cited in search report | | Publication date | Patent family member(s) | | Publication date |
|---|---|---|---|---|---|
| WO 2008063510 | A1 | 29-05-2008 | EP | 2082370 A1 | 29-07-2009 |
| | | | US | 2008137949 A1 | 12-06-2008 |
| EP 1796428 | A1 | 13-06-2007 | US | 2007127754 A1 | 07-06-2007 |

EPO FORM P0459

For more details about this annex : see Official Journal of the European Patent Office, No. 12/82

16

REFERENCES CITED IN THE DESCRIPTION

**Patent documents cited in the description**

- US 61104399 B